# FASCICULE DE BREVET EUROPEEN

(11) **EP 0 337 857 B1**
(45) Date de publication et mention de la délivrance du brevet: **17.03.1993**
(21) Numéro de dépôt: 89400951.3
(22) Date de dépôt: 06.04.1989
(51) Int. Cl.: H03K 17/06, H03K 17/04

(54) **Circuit de commande d'une charge inductive**
Steuerschaltung für eine induktive Last
Control circuit for an inductive load

(30) Priorité: 14.04.1988 FR 8804938
(43) Date de publication de la demande: 18.10.1989
(73) Titulaire: SIEMENS AKTIENGESELLSCHAFT, 80333 München (DE)
(72) Inventeur: Sicard, Thierry Michel Alain, F-31150 Fenouillet (FR); Suquet, Michel Joseph, F-31270 Villeneuve-Tolosane (FR)

(56) Documents cités:
- WO-A-86/02127
- US-A- 4 500 801
- US-A- 4 603 269
- INTERNATIONAL JOURNAL OF ELECTRONICS, vol. 56, no. 3, mars 1984, pages 429-431, Basingstoke, Hampshire, GB; C.F. CHRISTIANSEN et al.: "Wideband driver for power MOSFETs"
- PATENT ABSTRACTS OF JAPAN, vol. 8, no. 213 (E-269)[1650], 28 septembre 1984, page 38 E 269; & JP-A-59 97 223 (NISSAN JIDOSHA K.K.) 05-06-1984
- PATENT ABSTRACTS OF JAPAN, vol. 8, no. 103 (E-244)[1540], 15 mai 1984, page 85 E 244; & JP-A-59 19 432 (HITACHI SEISAKUSHO K.K.) 31-01-1984

## Description

La présente invention est relative à un circuit de commande d'une charge inductive et, plus particulièrement, à un tel circuit protégé contre les surtensions négatives qui apparaissent aux bornes de la charge, à la coupure de l'alimentation de cette charge.

En électronique automobile, des fonctions telles que l'allumage, la commande du temps d'injection, la modulation de la pression dans les circuits de freinage font appel à des charges inductives dont l'alimentation doit être commandée par des transistors de puissance. Comme exemples de telles charges inductives, on peut citer le bobinage d'un injecteur ou celui d'une électrovanne modulatrice d'une pression d'un liquide de freinage dans un dispositif d'antiblocage des roues d'un véhicule automobile. On peut citer encore la bobine d'un circuit primaire d'allumage inductif.

Le transistor de puissance utilisé pour commander l'alimentation d'une telle charge est couramment réalisé en technologie MOS, le circuit drain-source de ce transistor étant placé en série avec la charge, entre celle-ci et la borne positive de la source d'alimentation, une batterie de véhicule automobile en l'occurrence.

On sait que lorsqu'on coupe brusquement l'alimentation d'une charge inductive, il apparaît aussitôt aux bornes de celle-ci, une forte surtension négative. Dans le cas de la commande de l'alimentation d'une telle charge, il convient de prévoir des moyens pour empêcher que cette forte surtension négative ne perturbe alors le fonctionnement du circuit, par remise en conduction du transistor bloqué par exemple.

Une solution connue de ce problème consiste, dans le cas de la commande d'une charge inductive par un transistor de puissance MOS canal N placé du côté "alimentation" de la charge, à connecter le circuit drain-source d'un transistor MOS d'interconnexion entre la grille et la source du transistor de puissance, de manière que la mise en conduction du transistor d'interconnexion établisse une tension grille-source pour le transistor de puissance propre à maintenir son blocage.

Cependant, cette mesure n'est efficace que si ia grille du transistor de puissance est par ailleurs isolée du reste du circuit de commande. On peut penser à utiliser à cet effet une résistance isolée en polysilicium. Malheureusement, on ne sait pas réaliser de telles résistances présentant une valeur précise et il en résulte que la tension négative que peut supporter le circuit est alors aussi imprécise ou de mauvaise reproductibilité.

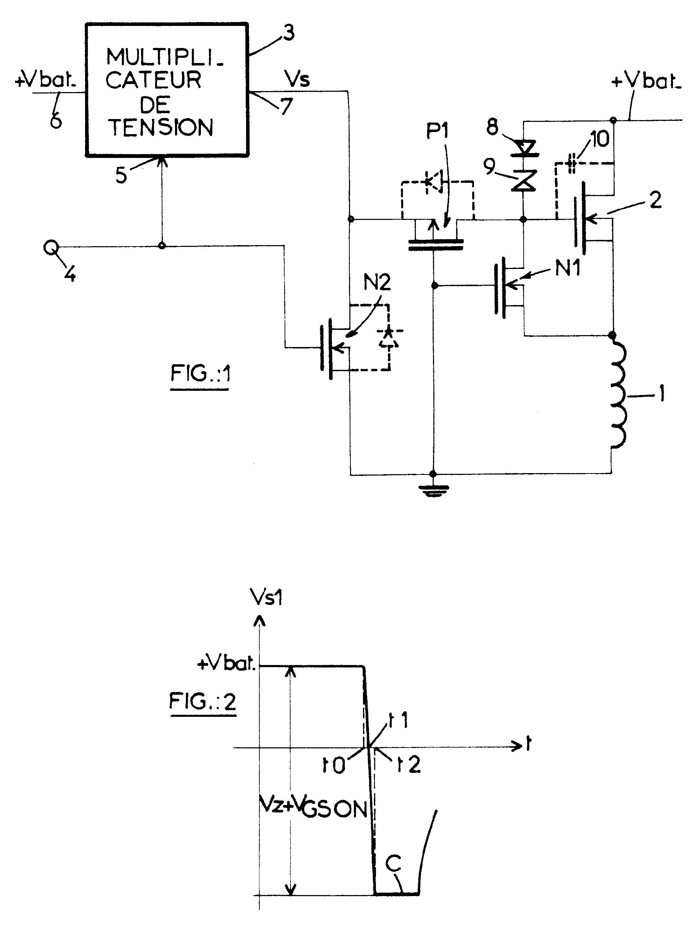

Un circuit de commande d'une charge, comprenant un transistor de puissance MOS canal N dont le drain est connecté à la borne positive d'une source d'alimentation électrique continue tandis que la charge est connectée entre la source de ce transistor et la masse, le circuit drain-source d'un transistor MOS canal N d'interconnexion étant connecté entre la grille et la source du transistor de puissance, ce circuit comprenant un transistor d'isolation MOS canal N dont la source est connectée à la grille du transistor de puissance est connu de l'article "Wideband driver for power MOSFETs", par C.F. Christiansen et al., International Journal of Electronics, Vol. 56, No.3, 1984, pages 429 à 431; cf. en particulier Figure 1.

La présente invention a donc pour but de réaliser un circuit de commande de charge inductive à transistor de puissance du type MOS canal N placé en série avec la charge du côté positif d'une source d'alimentation électrique, comprenant un transistor d'interconnexion entre sa grille et sa source, ce circuit comprenant des moyens assurant de manière précise et reproductible l'isolation de la grille du transistor de puissance lorsque des tensions négatives lui sont appliquées par l'intermédiaire du transistor d'interconnexion, lors d'une décharge de la charge inductive.

On atteint ce but de l'invention, ainsi que d'autres qui apparaîtront dans la suite, avec un circuit de commande d'une charge inductive, comprenant un transistor de puissance MOS canal N dont le drain est connecté à la borne positive d'une source d'alimentation électrique continue fournissant une tension +Vbat tandis que la charge inductive est connectée entre la source de ce transistor et la masse, le circuit drain-source d'un transistor MOS canal N d'interconnexion étant connecté entre la grille et la source du transistor de puissance alors que la grille du transistor MOS canal N est connectée à la masse, la tension du seuil de conduction du transistor MOS canal N d'interconnexion étant inférieure à celle du transistor de puissance, ce circuit comprenant un transistor d'isolation MOS canal P dont le drain et la grille sont connectés respectivement à la grille du transistor de puissance et à la masse du circuit, la source du transistor d'isolation étant sélectivement portée à une tension inférieure ou supérieure à +Vbat, pour bloquer ou débloquer la conduction du transistor de puissance, respectivement.

Le circuit comprend un multiplicateur de tension alimenté par la source d'alimentation continue pour fournir une tension de sortie Vs appliquée à la source du transistor d'isolation, le multiplicateur de tension étant commandé pour fournir sélectivement une tension Vs inférieure ou supérieure à la tension +Vbat de la source d'alimentation, de manière à commander le blocage ou le déblocage du transistor de puissance, respectivement.

Le circuit comprend aussi un troisième transistor MOS canal N dont le drain est relié à la source du transistor MOS canal P et la source est connecté à la masse du circuit, la grille de ce transistor étant connectée à une source d'un signal de commande de blocage/déblocage du transistor MOS de puissance.

La source de signal de commande est connectée à une entrée de commande du multiplicateur de tension, de manière que le signal de commande provoque sélectivement, soit la production par le multiplicateur d'une tension Vs supérieure à la tension +Vbat et le blocage du troisième transistor MOS canal N, soit la production par le multiplicateur d'une tension Vs inférieure à la tension +Vbat et le déblocage du troisième transistor MOS canal N.

Suivant un mode de réalisation avantageux de l'invention, le transistor MOS de puissance est intégré sur la même puce que le reste du circuit de commande qui prend la forme d'un circuit de puissance "intelligent".

Au dessin annexé, donné seulement à titre d'exemple :
- la figure 1 est un schéma du circuit de commande d'une charge inductive, suivant l'invention, et
- la figure 2 est un graphe de l'allure de l'évolution de la tension aux bornes de la charge inductive, lors du blocage du transistor de puissance commandant l'alimentation de cette charge.

On se réfère à la figure 1 du dessin où le circuit représenté sert à commander l'alimentation d'une charge inductive 1. Comme on l'a vu plus haut on trouve de telles charges inductives dans les injecteurs de carburant pour moteurs à combustion interne, dans les électrovannes modulatrices de la pression d'un liquide de freinage d'un dispositif d'antiblocage des roues d'un véhicule automobile, par exemple. L'excitation de tels actuateurs est déclenchée par le passage d'un courant dans un bobinage constituant la charge inductive, un commutateur électronique tel qu'un transistor de puissance 2 étant placé en série avec la charge inductive 1 pour commander le passage du courant.

Le transistor de puissance 2 utilisé dans le circuit de l'invention est un transistor MOS canal N (du type DMOS par exemple) dont le substrat est connecté classiquement à la source. Le drain du transistor 2 est relié à la borne positive d'une source d'alimentation électrique. Dans les applications "automobiles" de l'invention, cette source est constituée par la batterie d'un véhicule, qui délivre une tension +Vbat, de 12 volts par exemple. La source du transistor 2 est connectée à la charge 1. Le transistor 2 est ainsi connecté au point "chaud" du circuit, du côté de la borne positive de la batterie suivant une configuration couramment adoptée en électronique automobile.

Le circuit suivant l'invention comprend aussi un transistor N1 du type MOS canal N dont le drain et la source sont connectés respectivement à la grille et à la source du transistor 2. La grille du transistor N1 est connectée à la masse du circuit. Le transistor N1 commande une interconnexion de la grille et de la source du transistor 2, comme on le verra plus loin.

Suivant une caractéristique essentielle du circuit suivant l'invention, le drain d'un transistor P1 du type MOS canal P est connecté à la grille du transistor 2 tandis que la source est connectée au point commun à la sortie d'un multiplicateur de tension 3 et au drain d'un troisième transistor N2 du type MOS canal N dont la source est à la masse. Les substrats de tous ces transistors sont connectés à la source, de manière classique.

Le signal de commande de la commutation du transistor de puissance 2 est un signal logique à deux niveaux. Il est appliqué sur une broche d'entrée 4 du circuit, connectée d'une part à l'entrée de commande 5 du multiplicateur de tension et, d'autre part, à la grille du transistor N2.

Le multiplicateur de tension 3 est alimenté sur une entrée 6 par la batterie pour délivrer à sa sortie 7 une tension Vs de valeur supérieure à +Vbat sous la commande du signal reçu à son entrée 5. La tension Vs sert à commuter le transistor 2 dans son état passant, comme on le verra plus loin, pour assurer ainsi l'alimentation de la charge inductive 1.

Le circuit est complété par une diode 8 dont l'anode est reliée à une ligne portée à la tension +Vbat et dont la cathode est reliée à celle d'une diode de Zener 9, l'anode de cette diode de Zener étant elle-même connectée à la grille du transistor 2.

Suivant la présente invention, la tension de claquage Vz de la diode de Zener 9 est supérieure à +Vbat. Ainsi, comme on le verra plus loin, la diode 9 permet de limiter la tension négative qui apparaît aux bornes de la charge 1, à la coupure du courant dans cette charge. La diode 8 de son côté isole la grille du transistor 2 de la ligne +Vbat quand cette grille est portée à la tension de sortie Vs du multiplicateur 3, tension Vs qui est supérieure à +Vbat comme on l'a indiqué plus haut.

On explique maintenant le fonctionnement du circuit suivant l'invention, qui permet de conserver le blocage du transistor MOS de puissance quand une tension négative apparaît aux bornes de la charge inductive commandée par ce transistor.

Lorsque le signal de commande appliqué à la broche 4 du circuit est à son niveau "bas", le multiplicateur de tension est actif et délivre une tension Vs supérieure à +Vbat. Ce même signal de commande, appliqué à la grille du transistor N2 du type MOS canal N, bloque ce transistor. La tension grille-source du transistor P1 du type MOS canal P est alors négative ce qui rend ce transistor conducteur. La tension Vs est alors appliquée à la grille du transistor de puissance 2 qui conduit. La source du transistor 2 est alors à un potentiel voisin de +Vbat, à la chute de tension drain-source du transistor 2 près. La tension grille-source du transistor 2 est alors de l'ordre de (Vs-Vbat). Pour assurer une commutation franche du transistor 2, le multiplicateur de tension est conçu pour fournir une tension Vs supérieure d'une dizaine de volts à +Vbat. Dans ces conditions la charge inductive est alimentée par le courant fourni par la ligne +Vbat. On remarquera sur la figure 1 une capacité 10 représentée en pointillé, qui correspond à la capacité grille-drain du transistor 2, cette capacité étant alors chargée à la tension Vs-Vbat.

Si, à l'instant to (voir figure 2), le signal de commande appliqué à la broche 4 passe au niveau "haut", le multiplicateur de tension est rendu inactif et sa sortie 7 passe à un niveau de tension nul ce qui bloque le transistor 2 tandis que le transistor N2 se débloque. On observe alors tout d'abord une décharge de la capacité 10 à travers la diode intrinsèque du transistor P1 (figurée en pointillé sur la figure 1) et le transistor N2. Cette décharge se poursuit jusqu'à l'instant t1 (figure 2) où la tension Vsl aux bornes de la charge inductive 1 devient négative, comme suite au blocage du transistor 2. On remarquera la raideur de la partie de la courbe de la figure 2 qui suit l'instant to, raideur caractéristique de la décharge d'une charge inductive.

A partir de l'instant t1, la tension de source du transistor 2 étant négative alors que sa tension de grille est nulle, les conditions d'une remise en conduction du transistor 2 sont réunies. Une telle remise en conduction interromprait prématurément la décharge de la charge inductive. Pour éviter cela, suivant l'invention, on isole la grille du transistor 2 en bloquant le transistor P1 tandis que la remise en conduction du transistor N1 établit une tension grille-source nulle sur le transistor 2 qui empêche sa remise en conduction. Pour ce faire, le transistor N1 est choisi de manière à présenter une tension de seuil inférieure à celle du transistor de puissance 2. En l'absence d'isolation de la grille du transistor 2 par le blocage du transistor P1, on observerait en effet une impossibilité de maintenir la grille à une tension négative, car il y aurait alors décharge par la diode intrinsèque (représentée en pointillé) du transistor N2.

Le transistor P1 étant bloqué et le transistor N1 conduisant, la capacité 10 achève de se décharger par le circuit drain-source du transistor N1, après l'instant t1. La tension négative apparue aux bornes de la charge 1 continuant à croître il y a lieu de limiter cette croissance à une valeur supportable par le circuit. Dans le circuit suivant l'invention cette limitation est obtenue au moyen de la diode de Zener 9 qui présente une tension de claquage Vz supérieure en valeur absolue à +Vbat. Dès que la tension entre la grille du transistor 2 et la ligne à +Vbat dépasse la tension Vz (instant t2, figure 2), la diode 9 devient conductrice. Un courant est alors forcé dans la résistance équivalente Rdson du circuit drain-source du transistor N1. Il s'établit une tension grille-source Vgson sur le transistor 2 (partie C de la courbe de la figure 2) qui rétablit la conduction du transistor de puissance 2. Cette remise en conduction provoque ensuite un abaissement progressif du courant. Quand le courant est nul la tension s'abaisse progressivement à cause des courants de Foucault lorsque la charge inductive est associée à un noyau magnétique comme le montre l'allure de la courbe de la figure 2. Si la charge inductive est pure (self "à l'air") la chute de tension est brutale.

Le circuit suivant l'invention peut ainsi supporter les fortes tensions négatives qui apparaissent lors d'une décharge rapide de l'énergie accumulée dans la charge inductive qu'il commande. L'isolement obtenu à l'aide du transistor P1 du type MOS canal P est sans faille et n'introduit pas les défauts de reproductibilité remarqués sur les circuits de la technique antérieure.

Bien entendu, la protection suivant l'invention d'un circuit de commande de charge inductive pourrait être appliquée à la commande d'actuateurs ou autres organes utilisés ailleurs que dans des véhicules automobiles. L'invention s'étend à la commande de toute charge inductive, telle que, par exemple, un enroulement rotorique ou statorique de moteur électrique.

## Revendications

1. Circuit de commande d'une charge inductive, comprenant un transistor de puissance MOS canal N (2) dont le drain est connecté à la borne positive d'une source d'alimentation électrique continue fournissant une tension +Vbat tandis que la charge inductive (1) est connectée entre la source de ce transistor et la masse, le circuit drain-source d'un transistor (N1) MOS canal N d'interconnexion étant connecté entre la grille et la source du transistor de puissance, alors que la grille du transistor (N1) est connectée à la masse, la tension du seuil de conduction du transistor MOS canal N d'interconnexion (N1) étant inférieure à celle du transistor de puissant (2), ce circuit comprenant un transistor d'isolation (P1) MOS canal P dont le drain et la grille sont connectés respectivement à la grille du transistor de puissance (2) et à la masse du circuit, la source du transistor d'isolation (P1) étant sélectivement portée à une tension (Vₛ) inférieure ou supérieure à +Vbat, pour bloquer ou débloquer la conduction du transistor de puissance, respectivement.

2. Circuit conforme à la revendication 1, caractérisé en ce qu'il comprend un multiplicateur de tension (3) alimenté par la source d'alimentation continue pour fournir sélectivement une tension de sortie Vs appliquée à la source du transistor d'isolation (P1), le multiplicateur de tension étant commandé pour fournir sélectivement une tension Vs inférieure ou supérieure à la tension +Vbat de la source d'alimentation, de manière à commander le blocage ou le déblocage du transistor de puissance, respectivement.

3. Circuit conforme à la revendication 1 ou 2, caractérisé en ce qu'il comprend un troisième transistor (N2) MOS canal N dont le drain est relié à la source du transistor d'isolation (P1) MOS canal P et la source est connectée à la masse du circuit, la grille de ce transistor étant connectée à une source d'un signal de commande de blocage/déblocage du transistor MOS de puissance.

4. Circuit conforme à l'ensemble des revendications précédentes, caractérisé en ce que la source de signal de commande est connectée à une entrée de commande (5) du multiplicateur de tension, de manière que le signal de commande provoque sélectivement, soit la production par le multiplicateur d'une tension de sortie Vs supérieure à la tension +Vbat et le blocage du troisième transistor (N2) MOS canal N, soit la production par le multiplicateur d'une tension de sortie inférieure à la tension +Vbat et le déblocage du troisième transistor (N2) MOS canal N.

5. Circuit conforme à la revendication 4, caractérisé en ce que le signal de commande est un signal logique, la sortie du multiplicateur de tension étant à la tension Vs supérieure ou inférieure à +Vbat suivant que le signal logique est "bas" ou "haut".

6. Circuit conforme à l'une quelconque des revendications précédentes, caractérisé en ce qu'il comprend une diode de Zener (9) connectée en inverse entre la borne positive de la source d'alimentation et la jonction du drain du transistor d'isolation (P1) à la grille du transistor de puissance, cette diode présentant une tension de claquage Vz supérieure à la tension +Vbat pour limiter l'amplitude de l'évolution négative de la tension aux bornes de la charge, au blocage du transistor de puissance.

7. Circuit conforme à la revendication 6, caractérisé en ce qu'une diode d'isolation (8) est connectée entre la source +Vbat et la diode de Zener, l'anode de la diode étant reliée à la source +Vbat.

8. Circuit conforme à l'une quelconque des revendications précédentes, caractérisé en ce que tous les transistors MOS du circuit ont leur substrat connecté à la source.

9. Circuit conforme à l'une quelconque des revencidations précédentes, caractérisé en ce que le transistor MOS de puissance est intégré sur la même puce que le reste du circuit de commande qui prend la forme d'un circuit de puissance "intelligent".

## Claims

1. Control circuit for an inductive load, comprising an N-channel MOS power transistor (2), the drain of which is connected to the positive terminal of a direct current electrical supply source supplying a voltage +Vbat while the inductive load (1) is connected between the source of this transistor and earth, the drain-source circuit of an N-channel MOS interconnecting transistor (N1) being connected between the gate and the source of the power transistor, whilst the gate at the transistor (N₁) is connected to ground earth, the voltage of the conduction threshold of the N-channel MOS interconnecting transistor (N1) being below that of the power transistor (2), this circuit comprising a P-channel MOS isolating transistor (P1), the drain and the gate of which are connected respectively to the gate of the power transistor (2) and to the earth of the circuit, the source of the isolating transistor (P1) being selectively brought to a voltage (Vₛ) less than or greater than +Vbat, to block or to unblock the conduction of the power transistor, respectively.

2. Circuit according to Claim 1, characterised in that it comprises a voltage multiplier (3) supplied by the direct current supply source to supply selectively an output voltage Vs applied to the source of the isolating transistor (P1), the voltage multiplier being controlled to supply selectively a voltage Vs less than or greater than the voltage +Vbat of the supply source, In such a manner as to control the blocking or the unblocking of the power transistor, respectively.

3. Circuit according to Claim 1 or 2, characterised In that it comprises a third N-channel MOS transistor (N2), the drain of which is connected to the source of the P-channel MOS isolating transistor (P1) and the source of which is connected to the earth of the circuit, the gate of this transistor being connected to a source of a control signal for blocking/unblocking the MOS power transistor.

4. Circuit according to all the preceding claims, characterised in that the control signal source Is connected to a control input (5) of the voltage multiplier, in such a manner that the control signal causes selectively either the production by the multiplier of an output voltage Vs greater than the voltage +Vbat and the blocking of the third N-channel MOS transistor (N2) or the production by the multiplier of an output voltage less than the voltage +Vbat and the unblocking of the third N-channel MOS transistor (N2).

5. Circuit according to Claim 4, characterised in that the control signal is a logic signal, the output of the voltage multiplier being at the voltage Vs which is greater than or less than +Vbat, depending upon whether the logic signal is "low" or "high".

6. Circuit according to any one of the preceding claims, characterised in that it comprises a Zener diode (9) connected in reverse between the positive terminal of the supply source and the junction of the drain of the isolating transistor (P1) at the gate of the power transistor, this diode exhibiting a breakdown voltage Vz which is greater than the voltage +Vbat to limit the amplitude of the negative development of the voltage at the terminals of the load, to the blocking of the power transistor.

7. Circuit according to Claim 6, characterised in that an isolating diode (8) is connected between the source +Vbat and the Zener diode, the anode of the diode being connected to the source +Vbat.

8. Circuit according to any one of the preceding claims, characterised In that all the MOS transistors of the circuit have their substrate connected to the source.

9. Circuit according to any one of the preceding claims, characterised In that the MOS power transistor Is integrated on the same chip as the remainder of the control circuit, which takes the form of a "smart" power circuit.

## Patentansprüche

1. Steuerschaltung für eine induktive Last mit einem N-Kanal-MOS-Leistungstransistor (2), dessen Drain mit der positiven Klemme einer elektrischen Gleichstrom-Versorgungsquelle verbunden ist, die eine Spannung +Vbat liefert, während die induktive Last (1) zwischen die Source dieses Transistors und Masse geschaltet ist, wobei der Drain-Source-Kreis eines N-Kanal-MOS-Verbindungstransistors (N1) zwischen das Gate und die Source des Leistungstransistors geschaltet ist, während das Gate des Transistors (N1) an Masse liegt, wobei die Schwellwertspannung zum Durchschalten des MOS-Verbindungstransistors (N1) kleiner ist als die des Leistungstransistors (2), wobei diese Schaltung einen P-Kanal-MOS-Isoliertransistor (P1) aufweist, dessen Drain und Gate mit dem Gate des Leistungstransistors (2) bzw. der Masse der Schaltung verbunden ist, wobei die Source des Isoliertransistors (P1) wahlweise mit einer Spannung (Vs) beaufschlagbar ist, die kleiner oder größer als +Vbat ist, um den Leistungstransistor zu sperren bzw. durchzuschalten.

2. Schaltung nach Anspruch 1, dadurch gekennzeichnet, daß sie einen Spannungsvervielfacher (3) aufweist, der von der Versorgungsquelle gespeist wird, um wahlweise eine Ausgangsspannung (Vs) an die Source des Isoliertransistors (P1) anzulegen, wobei der Spannungsvervielfacher so gesteuert wird, daß er wahlweise eine Spannung (Vs) liefert, die kleiner oder größer als die Spannung +Vbat der Versorgungsquelle ist und somit das Sperren bzw. Durchschalten des Leistungstransistors steuert.

3. Schaltung nach Anspruch 1 oder 2, dadurch gekennzeichnet, daß sie einen dritten N-Kanal-MOS-Transistor (N2) aufweist, dessen Drain mit der Source des P-Kanal-MOS-Isoliertransistors (P1) und dessen Source mit der Masse der Schaltung verbunden ist, wobei das Gate dieses Transistors mit einer Signalquelle für ein Steuersignal zum Sperren/Durchschalten des MOS-Leistungstransistors verbunden ist.

4. Schaltung nach allen vorhergehenden Ansprüchen, dadurch gekennzeichnet, daß die Signalquelle für das Steuersignal mit einem Steuereingang (5) des Spannungsvervielfachers verbunden ist, derart, daß das Steuersignal wahlweise bewirkt, daß entweder der Spannungsvervielfacher eine Ausgangsspannung (Vs), die größer als die Spannung +Vbat ist, erzeugt, und der dritte N-Kanal-MOS-Transistor (N2) gesperrt wird, oder daß der Spannungsvervielfacher eine Ausgangsspannung erzeugt, die kleiner als die Spannung +Vbat ist, und der dritte N-Kanal-MOS-Transistor (N2) durchgeschaltet wird.

5. Schaltung nach Anspruch 4, dadurch gekennzeichnet, daß das Steuersignal ein Logiksignal ist, wobei am Ausgang des Spannungsvervielfachers eine Spannung (Vs) anliegt, die größer oder kleiner als +Vbat ist, je nachdem, ob das Logiksignal "low" oder "high" ist.

6. Schaltung nach einem der vorhergehenden Ansprüche, dadurch gekennzeichnet, daß sie eine Zenerdiode (9) aufweist, die in inverser Schaltung zwischen die positive Klemme der Versorgungsquelle und die Verbindungsstelle des Drains des Isoliertransistors (P1) mit dem Gate des Leistungstransistors geschaltet ist, wobei diese Diode eine Durchbruchspannung (Vz) aufweist, die größer als die Spannung +Vbat ist, um die Amplitude des negativen Verlaufs der Spannung an den Klemmen der Last beim Sperren des Leistungstransistors zu begrenzen.

7. Schaltung nach Anspruch 6, dadurch gekennzeichnet, daß eine Isolierdiode (8) zwischen die Quelle +Vbat und die Zenerdiode geschaltet ist, wobei die Anode der Diode mit der quelle +Vbat verbunden ist.

8. Schaltung nach einem der vorhergehenden Ansprüche, dadurch gekennzeichnet, daß sämtliche MOS-Transistoren der Schaltung mit ihrem Substrat an der Source angeschlossen sind.

9. Schaltung nach einem der vorhergehenden Ansprüche, dadurch gekennzeichnet, daß der MOS-Leistungstransistor in dem selben Chip wie die übrige Steuerschaltung, die als "intelligente" Leistungsschaltung ausgebildet ist, integriert ist.
